# EUROPEAN PATENT APPLICATION

(11) **EP 4 567 808 A1**
(43) Date of publication of application: **11.06.2025**
(21) Application number: 24217871.3
(22) Date of filing: 05.12.2024
(51) Int. Cl.: G11C 11/406

(54) **MEMORY DEVICE SUPPORTING ROW HAMMER, REFRESH OPERATION, AND OPERATION METHOD THEREOF**

(30) Priority: 06.12.2023 KR 20230176032; 14.05.2024 KR 20240063449
(71) Applicant: Samsung Electronics Co., Ltd., Suwon-si, Gyeonggi-do 16677 (KR)
(72) Inventor: SHIN, Hoon, 16677 Suwon-si (KR); SHIN, Minchur, 16677 Suwon-si (KR); KIM, Ki-Heung, 16677 Suwon-si (KR); SEOL, Hoseok, 16677 Suwon-si (KR)
(74) Representative: Marks & Clerk LLP

(57) **Abstract**

A memory device includes at least one bank including memory cells, and a register corresponding to the at least one bank. The bank includes a plurality of rows that are arranged in a row direction, and a plurality of count cells, each of which stores count data associated with the number of times of access of each of the plurality of rows. The register stores an address and count data, which are associated with at least one row among the plurality of rows.

## Description

### BACKGROUND

A memory device is used to store data and is classified as a volatile memory device or a nonvolatile memory device. The volatile memory device refers to a memory device which loses data stored therein when a power is turned off. As the volatile memory device, a dynamic random access memory (DRAM) is used in various fields, such as a mobile system, a server, and a graphics device.

Meanwhile, when a specific word line is accessed aggressively, a row hammer phenomenon, in which data stored in memory cells connected to a word line adjacent to the corresponding word line are lost, may occur. Accordingly, a memory device is desired to be capable of preventing the row hammer phenomenon effectively.

### SUMMARY

In general, in some aspects, the present disclosure is directed to a memory device capable of preventing a row hammer phenomenon effectively.

According to some implementations, the present disclosure is directed to a memory device comprising at least one bank including memory cells, and a register corresponding to the at least one bank, wherein the at least one bank includes a plurality of rows arranged in a row direction; and a plurality of count cells each configured to store count data associated with the number of times of access of each of the plurality of rows, and wherein the register is configured to store an address and count data, which are associated with at least one row among the plurality of rows.

According to some implementations, the present disclosure is directed to an operating method of a memory device, the method comprising managing count data being the number of times of access of each of a plurality of rows, by using count cells of a count cell area of a bank, managing an address and the count data, which are associated with at least one row among the plurality of rows, by using a register, and performing a row hammer refresh operation, based on the address and the count data of the at least one row managed in the register.

According to some implementations, the present disclosure is directed to a memory device comprising a bank including a plurality of count cells each configured to store count data being the number of times of access of each of the plurality of word lines, a register configured to store at least some count data among the plurality of count data stored in the plurality of count cells, and a row hammer management circuit configured to manage the plurality of count data stored in the plurality of count cells and the at least some count data stored in the register, wherein the row hammer management circuit updates the register, based on a comparison result of modified count data corresponding to an access-requested word line and the at least some count data stored in the register.

At least some of the above and other features of the invention are set out in the claims.

### BRIEF DESCRIPTION OF THE DRAWINGS

Example implementations will be more clearly understood from the following detailed description, taken in conjunctions with the accompanying drawings.
FIG. 1 is a block diagram illustrating an example of a memory system according to some implementations.
FIG. 2 is a flowchart for describing an example of an operation of a memory device according to some implementations.
FIG. 3 is a block diagram illustrating another example of a memory system according to some implementations.
FIG. 4 is a diagram illustrating an example of a bank according to some implementations.
FIG. 5A is a diagram showing an example of a configuration of a bank, in which the count cell area CCA implemented to include count cells is included according to some implementations.
FIG. 5B is a diagram showing an example of a configuration of a bank, in which the count cell area CCA implemented to include count cells and parity cells is included according to some implementations.
FIGS. 6A and 6B are diagrams showing examples of a register managing an address and count data of a row according to some implementations.
FIG. 7 is a block diagram illustrating an example of a memory device according to some implementations.
FIG. 8 is a diagram illustrating an example of a bank array according to some implementations.
FIGS. 9 and 10 are diagrams showing an example of an operation of a memory device which manages count data through a count cell area according to some implementations.
FIGS. 11 and 12 are diagrams showing an example of an operation of a memory device which manages count data through a count cell area according to some implementations.
FIGS. 13, 14A, and 14B are diagrams showing an example of an operation of a memory device which manages relatively large count data by using a register according to some implementations.
FIGS. 15 and 16 are diagrams showing an example of an operation of a memory device which manages relatively large count data by using a register according to some implementations.
FIGS. 17 and 18 are diagrams showing an example of an operation of a memory device which manages relatively large count data by using a register according to some implementations.
FIGS. 19 and 20 are diagrams showing an example of an operation of a memory device which manages relatively large count data by using a register according to some implementations.
FIGS. 21, 22A, and 22B are diagrams showing an example of an operation of a memory device which performs a row hammer refresh operation based on information of a row managed in a register according to some implementations.
FIGS. 23 and 24 are diagrams showing an example of an operation of a memory device which performs a row hammer refresh operation based on information of a row managed in a register according to some implementations.
FIGS. 25 is a flowchart showing an example of an operation of a memory device which performs a row hammer refresh operation based on information of a row managed in a register according to some implementations.

### DETAILED DESCRIPTION

Hereinafter, example implementations will be described with reference to the accompanying drawings.

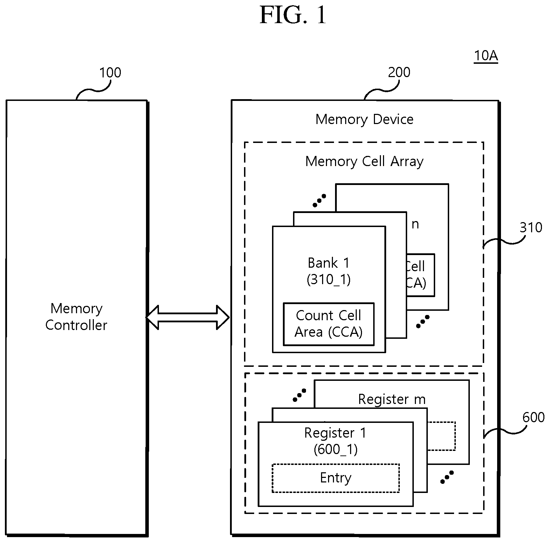

FIG. 1 is a block diagram illustrating an example of a memory system according to some implementations. In FIG. 1,a memory device 200 may include a memory cell array 310, and the memory cell array 310 may include a plurality of count cells respectively corresponding to a plurality of rows. Each count cell may store count data indicating the number of times of access of the corresponding row.

The memory device 200 may include at least one register, and the register may store an address and count data, which are associated with at least one row among the plurality of rows of the memory cell array 310. For example, the register may store an address and count data, which are associated with at least one row having relatively large count data from among the plurality of rows. In a row hammer refresh operation, the memory device 200 may perform the row hammer refresh operation based on information of the row managed in the register. Accordingly, the memory device 200 may manage the risk of occurrence of the row hammer phenomenon to be an appropriate level or lower. This may mean that the row hammer phenomenon is effectively prevented.

In FIG. 1, a memory system 10A may include a memory controller 100 and the memory device 200. The memory controller 100 may control the memory device 200. For example, the memory controller 100 may control the memory device 200 depending on a request of a processor supporting various applications, such as a server application, a personal computer (PC) application, and a mobile application. For example, the memory controller 100 may include a processor and may control the memory device 200 depending on a request of the processor.

To control the memory device 200, the memory controller 100 may transmit a command and/or an address to the memory device 200. Also, the memory controller 100 may transmit data to the memory device 200 or may receive data from the memory device 200.

The memory device 200 may receive data from the memory controller 100 and may store the received data. In response to a request of the memory controller 100, the memory device 200 may read the stored data and may transmit the read data to the memory controller 100.

In some implementations, the memory device 200 may be a memory device including volatile memory cells. For example, the memory device 200 may include various dynamic random access memory (DRAM) devices, such as a double data rate synchronous DRAM (DDR SDRAM), a DDR2 SDRAM, a DDR3 SDRAM, a DDR4 SDRAM, a DDR5 SDRAM, a DDR6 SDRAM, a low power double data rate (LPDDR) SDRAM, LPDDR2 SDRAM, an LPDDR3 SDRAM, an LPDDR4 SDRAM, an LPDDR4X SDRAM, an LPDDR5 SDRAM, an LPDDR6 SDRAM, a graphics double data rate synchronous graphics random access memory (GDDR SGRAM), a GDDR2 SGRAM, a GDDR3 SGRAM, a GDDR4 SGRAM, a GDDR5 SGRAM, and a GDDR6 SGRAM.

In some implementations, the memory device 200 may be a stacked memory device, in which DRAM dies are stacked, such as a high bandwidth memory (HBM), an HBM2, or an HBM3.

In some implementations, the memory device 200 may be a memory module, such as a dual in-line memory module (DIMM). For example, the memory device 200 may be a registered DIMM (RDIMM), a load reduced DIMM (LRDIMM), an unbuffered DIMM (UDIMM), a fully buffered DIMM (FB-DIMM), or a small outline DIMM (SO-DIMM). However, this is provided as an example, and the memory device 200 may be any other memory module such as a single in-line memory module (SIMM).

In some implementations, the memory device 200 may be an SRAM device, a NAND flash memory device, a NOR flash memory device, an RRAM device, an FRAM device, a PRAM device, a TRAM device, an MRAM device, etc.

The memory device 200 may include the memory cell array 310 and a register group 600.

The memory cell array 310 may include a plurality of banks 310_1 to 310_n, each of which includes memory cells for storing data. For convenience of description, it is presumed that each bank includes DRAM cells. However, in some implementations, and each of the plurality of banks 310_1 to 310_n may be implemented to include any other volatile memory cells except for the DRAM cells. In some implementations, the plurality of banks 310_1 to 310_n may be implemented to include the same kind of memory cells or may be implemented to include different kinds of memory cells.

Each of the plurality of banks 310_1 to 310_n may include a plurality of rows. In some implementations, the row may refer to a conductive line which is disposed to extend in a row direction and is electrically connected to memory cells. For example, one row may refer to one word line disposed to extend in the row direction. However, this is provided as an example. According to some implementations, one row may refer to a plurality of word lines disposed to extend in the row direction.

Each of the plurality of banks 310_1 to 310_n may include a count cell area CCA. The count cell area CCA may include a plurality of count cells, and each of the plurality of count cells may store the number of times of access of the corresponding row as count data.

For example, when a target row is accessed, count data may be read from a count cell corresponding to the target row being in an active state. Afterwards, the read count data may be modified, and the modified count data may be again written in the count cell corresponding to the target row. The number of times of access of each of the plurality of rows may be stored in the corresponding count cell through the read-modify-write (RMW) operation.

In some implementations, some of memory cells connected to one row may be used as a count cell. In this case, the count cell area CCA may include count cells associated with each of the plurality of rows.

In some implementations, some of memory cells connected to one row may be used as a count cell, and others thereof may be used as a parity cell. A parity cell may store parity data for performing an error correction operation on count data. In this case, the count cell area CCA may include count cells and parity cells for each of the plurality of rows.

Meanwhile, in FIG. 1, the description is given as each of the plurality of banks 310_1 to 310_n includes the count cell area CCA. However, this is provided as an example. In some implementations, some of the plurality of banks 310_1 to 310_n may not include the count cell area CCA. In an embodiment, different banks may share the same count cell area CCA. For example, when different banks share the same word line, only any one bank among the different banks may include the count cell area CCA, and the remaining banks may share and use the corresponding count cell area CCA.

The register group 600 may include a plurality of registers 600_1 to 600_m. In an embodiment, one register may correspond to one bank. In some implementations, one register may correspond to a plurality of banks.

In some implementations, each of the plurality of registers 600_1 to 600_m may store information about some of a plurality of rows included in the corresponding bank. For example, each of the plurality of registers 600_1 to 600_m may store an address and count data, which are associated with a row having relatively large count data from among the plurality of rows included in the corresponding bank. In this case, an address and count data associated with one row managed in the register may be referred to as an "entry".

In some implementations, the register may be updated based on a comparison result an address and modified count data of a target row with an address and count data managed in the register.

For example, the register may include a plurality of entries. In this case, when at least one of pieces of count data of the entries of the register is smaller than the count data of the target row, an entry of the register, which corresponds to the minimum count data, may be replaced with the address and the count data of the target row.

For example, the register may include one register. In this case, when count data of the entry of the register are smaller than the count data of the target row, the entry of the register may be replaced with the address and the count data of the target row.

For example, the address of the entry of the register may coincide with the address of the target row. In this case, previous count data of the entry of the register corresponding to the target row may be updated to be changed to newly modified count data.

As described above, the memory device 200 may manage an address and count data associated with a row having relatively large count data from among a plurality of rows of a bank by using the register, based on a comparison result of an address and/or count information of a target row and an address and/or count information of a row managed in the register.

In the row hammer refresh operation, the memory device 200 may perform the row hammer refresh operation based on information of a row managed in the register. For example, the memory device 200 may designate a row having the maximum count data from among rows managed in the register as a management aggressor row and may perform the refresh operation on a victim row adjacent to the management aggressor row. Accordingly, the row hammer refresh operation may be performed in association with a row having the maximum count data from among rows accessed during a given time from a current time point. As a result, the memory device 200 may manage the risk of occurrence of the per row hammer phenomenon to be an appropriate level or lower. This may mean that the per row hammer phenomenon is effectively prevented.

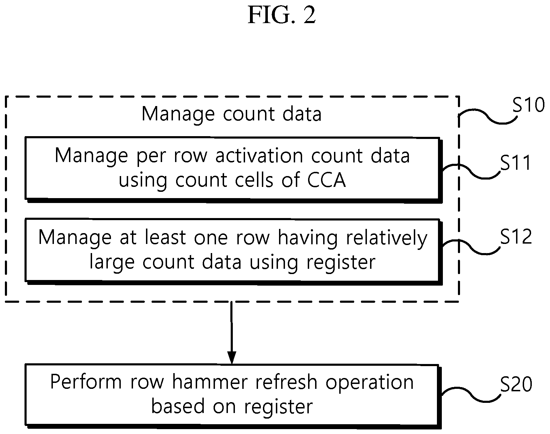

FIG. 2 is a flowchart showing an example of an operation of a memory device according to some implementations. An operation method to be described with reference to FIG. 2 may correspond to the operation method of the memory device 200 of FIG. 1.

In operation S10, an operation of managing count data may be performed. For example, in operation S11, the memory device 200 (refer to FIG. 1) may manage count data being the number of times of access of each of a plurality of rows included in a bank, by using the count cells of the count cell area CCA. In this case, count data stored in a count cell may be referred to as "per row activation count data or PRAC data"

Also, for example, in operation S12, the memory device 200 may manage a row having relatively large count data from among the plurality of rows included in the bank, by using the register. For example, the memory device 200 may manage an address and count data associated with a row having relatively large count data from among the plurality of rows included in the bank by using the register, based on a comparison result of an address and/or count information of a target row and an address and/or count information of a row managed in the register.

In this case, the operation of managing the count data by using the count cell area CCA and the operation of managing the row with relatively large count data by using the register may be sequentially performed or may be performed to overlap each other on time.

In operation S20, the row hammer refresh operation may be performed based on the register. For example, the memory device 200 may designate a row having the maximum count data from among rows managed in the register as a management aggressor row and may perform the refresh operation on a victim row adjacent to the management aggressor row. In this case, the management aggressor row may be a row having the maximum count data from among rows accessed during a given time from a current time point. Accordingly, the memory device 200 may manage the risk of occurrence of the per row hammer phenomenon to be an appropriate level or lower. This may mean that the row hammer phenomenon is effectively prevented.

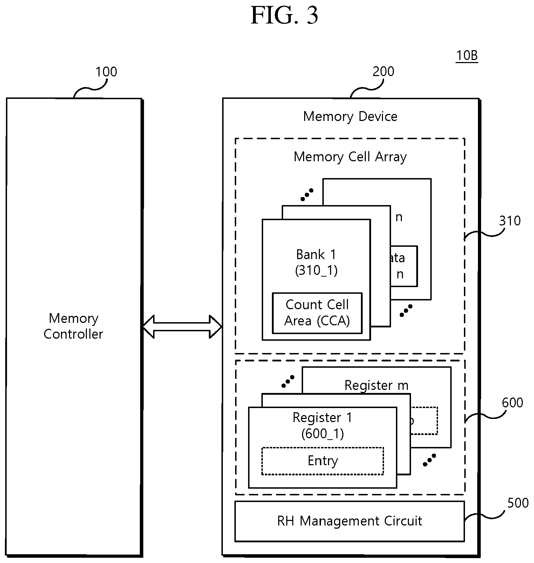

FIG. 3 is a block diagram illustrating an example of a memory system according to some implementations. A memory system 10B of FIG. 3 is similar to the memory system 10A of FIG. 1. Accordingly, the same or similar components may be marked by the same or similar reference numerals/signs, and additional description associated with the same or similar components will be omitted to omitted redundancy.

In FIG. 3, the memory system 10B may include the memory controller 100 and the memory device 200. The memory device 200 may include the memory cell array 310, the register group 600, and a row hammer management circuit 500.

The memory cell array 310 may include a plurality of banks 310_1 to 310_n, and each of the plurality of banks 310_1 to 310_n may include the count cell area CCA. The count cell area CCA may include a plurality of count cells corresponding to a plurality of rows, and each of the plurality of count cells may store the number of times of access of the corresponding row as count data.

The register group 600 may include the plurality of registers 600_1 to 600_m, and each of the plurality of registers 600_1 to 600_m may store an address and count data, which are associated with a row having relatively large count data from among the plurality of rows included in the corresponding bank.

The row hammer management circuit 500 may manage the number of times of access of each of the plurality of rows, based on a command received from the memory controller 100. For example, when a word line is activated depending on the active command received from the memory controller 100, the row hammer management circuit 500 may count the number of times of activation of a target row corresponding to the activated word line. Afterwards, the row hammer management circuit 500 may store count data being the number of times of activation in the count cell associated with the corresponding target row. However, this is provided as an example, and the row hammer management circuit 500 may count the number of times of access of the target row based on a precharge command.

In some implementations, the row hammer management circuit 500 may manage the number of times of access of each of the plurality of rows through the RMW operation. For example, when the active command for the target row is applied from the memory controller 100, the row hammer management circuit 500 may perform the RMW operation by reading count data from a count cell of the target row, generating modified count data by increasing the read count data as much as "1", and again writing the modified count data in the count cell of the target row.

In some implementations, the row hammer management circuit 500 may manage the number of times of access of each of the plurality of rows further in consideration of an activation time of the target row. For example, when the activation time of the target row exceeds a reference time, the row hammer management circuit 500 may generate the modified count data by further increasing the read count data as much as "k" (k being a natural number of 1 or more). In other words, when the activation time of the target row exceeds the reference time, the row hammer management circuit 500 may increase the number of times of access of the corresponding target row as much as "2" or more. Accordingly, the risk of losing data due to a passing gate effect (PGE) phenomenon of a memory cell may decrease.

In some implementations, the row hammer management circuit 500 may update the register group 600 by using the modified count data of the target row generated through the RMW operation. For example, the row hammer management circuit 500 may select a register, which corresponds to a bank to which the target row belongs, from among registers of the register group 600. Afterwards, the row hammer management circuit 500 may compare addresses and/or count data of rows managed in the selected register with the address and/or the modified count data of the target row and may update the register based on a comparison result.

In some implementations, when an entry corresponding to the target row is already present in the register, the row hammer management circuit 500 may update count data of the entry corresponding to the target row by using the modified count data.

In some implementations, when at least one of pieces of count data of entries of the register is smaller than the count data of the target row, the row hammer management circuit 500 may replace the entry of the register corresponding to the minimum count data with the address and the modified count data of the target row.

In some implementations, when an entry corresponding to the target row is absent from the register and an empty space is present in the register, the row hammer management circuit 500 may generate a new entry in the register by using the address and the modified count data of the target row.

In some implementations, when the modified count data are smaller than or equal to a reference value, the row hammer management circuit 500 may not apply the modified count data to the register. For example, when the modified count data are smaller than or equal to the reference value, the row hammer management circuit 500 may not generate a new entry for the target row in the register even though an empty space is present in the register.

In some implementations, the memory device 200 may perform the row hammer refresh operation at various opportunities. For example, the memory device 200 may perform the row hammer refresh operation in response to a refresh management (RFM) command received from the memory controller 100. As another example, when a normal refresh operation is performed, the memory device 200 may perform the row hammer refresh operation together. As another example, when the memory device 200 is in an idle state or the background operation is performed, the memory device 200 may perform the row hammer refresh operation.

In this case, the memory device 200 may perform the row hammer refresh operation based on the register of the register group 600. That is, the memory device 200 may select a management aggressor row and a victim row, based on information of a row managed in the register of the register group 600 and may perform the refresh operation on the victim row.

For example, the memory device 200 may designate a row having the maximum count data from among rows managed in the register as a management aggressor row. Accordingly, a row having the maximum count data from among rows accessed during a given time from a current time point may be designated as a management aggressor row. Afterwards, the memory device 200 may select at least one row adjacent to the management aggressor row as a victim row and may perform a victim row refresh operation on the selected victim row. As a result, the memory device 200 may manage the risk of occurrence of the per row hammer phenomenon to be an appropriate level or lower. This may mean that the per row hammer phenomenon is effectively prevented.

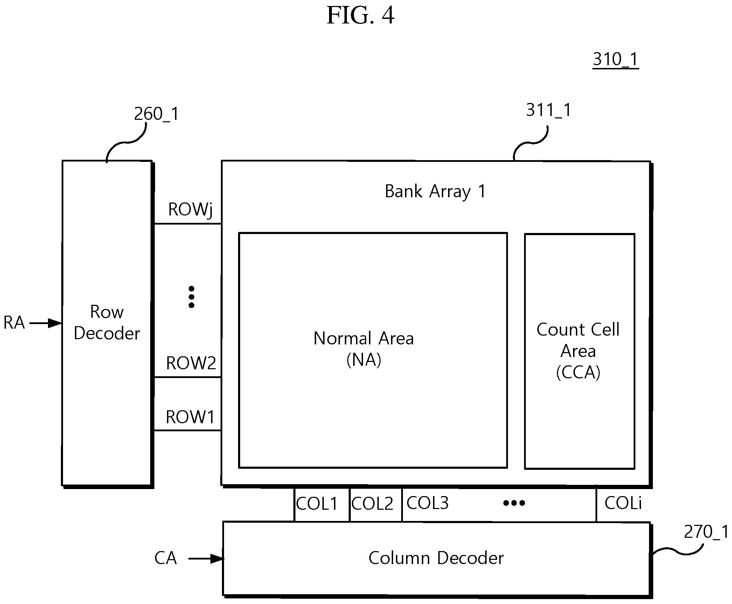

FIG. 4 is a diagram illustrating an example of a bank according to some implementations. The bank 310_1 of FIG. 4 may correspond, for example, to the first bank 310_1 of FIGS. 1 and 3.

In FIG. 4, the first bank 310_1 may include a first bank array 311_1, a row decoder 260_1, and a column decoder 270_1. The first bank array 311_1 may include a plurality of memory cells. The first bank array 311_1 may include a normal area NR and the count cell area CCA. The normal area NR may refer to an area of the first bank array 311_1, which is allocated to store user data. In some implementations, the normal area NR may refer to the remaining area of the first bank array 311_1 other than an area allocated to the count cell area CCA. The count cell area CCA may refer to an area of the first bank array 311_1, which is allocated to store count data for each of a plurality of rows ROW1 to ROWj.

The row decoder 260_1 may activate one of the plurality of rows ROW1 to ROWj in response to a row address RA. For example, each of the plurality of rows ROW1 to ROWj may correspond to a word line.

The column decoder 270_1 may activate one of a plurality of columns COL1 to COLi in response to a column address CA. For example, each of the plurality of columns COL1 to COLi may correspond to a column selection line (CSL). However, this is provided as an example. According to some implementations, each of the plurality of columns COL1 to COLi may correspond to a bit line.

In some implementations, the count cell area CCA may be implemented to include count cells for storing count data of the plurality of rows ROW1 to ROWj.

In some implementations, the count cell area CCA may be implemented to include count cells for storing the count data of the plurality of rows ROW1 to ROWj and parity cells for performing the error correction operation on the count data.

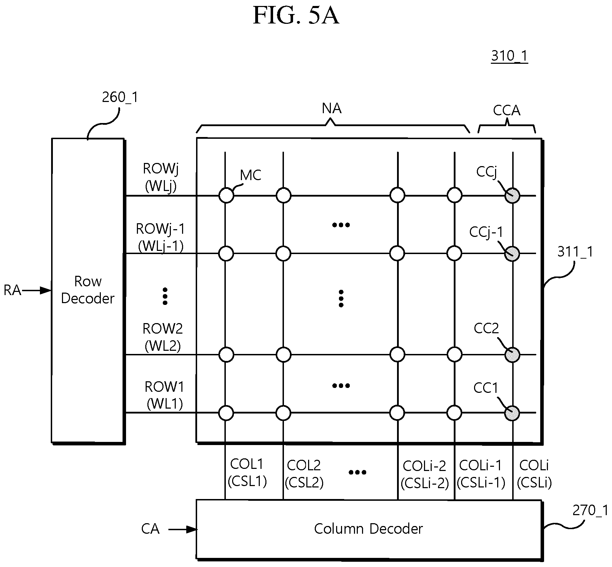

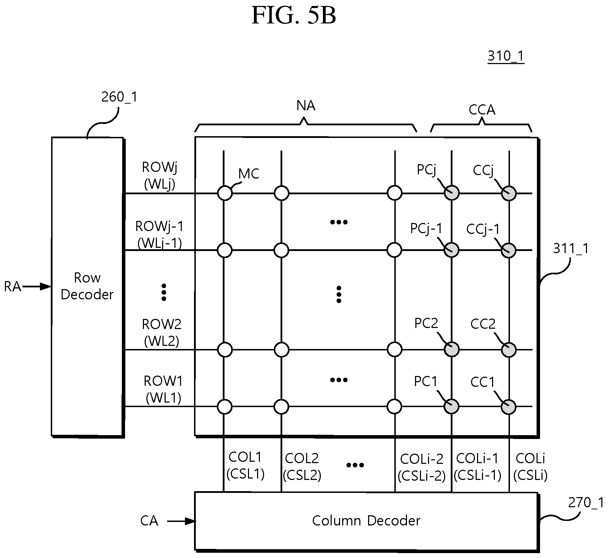

FIG. 5A is a diagram showing an example of a configuration of a bank, in which the count cell area CCA implemented to include count cells is included according to some implementations. FIG. 5B is a diagram showing an example of a configuration of a bank, in which the count cell area CCA implemented to include count cells and parity cells is included according to some implementations. The bank 310_1 to be described with reference to FIGS. 5A and 5B may correspond, for example, to the first bank 310_1 of FIGS. 1, 3, and 4.

In FIGS. 5A and 5B, the first bank 310_1 may include the first bank array 311_1, the row decoder 260_1, and the column decoder 270_1. The first bank array 311_1 may include a plurality of memory cells which are electrically connected to a plurality of word lines WL1 to WLj and a plurality of column selection lines CSL1 to CSLi. The plurality of word lines WL1 to WLj may be defined as the plurality of rows ROW1 to ROWj, and the plurality of column selection lines CSL1 to CSLi may be defined as the plurality of columns COL1 to COLi. A portion of the first bank array 311_1 may be allocated to the normal area NR, and the remaining portion thereof may be allocated to the count cell area CCA. For example, as illustrated in FIG. 5A, memory cells corresponding to one of the plurality of columns COL1 to COLi may be allocated to the count cell area CCA.

Accordingly, each of a plurality of memory cells CC1 to CCj allocated to the count cell area CCA may store count data of the corresponding row. The memory cells CC1 to CCj storing the count data may be referred to as "count cells". For example, the first count cell CC1 may store count data of the first row ROW1, the second count cell CC2 may store count data of the second row ROW2, and the j-th count cell CCj may store count data of the j-th row ROWj.

In some implementations, as illustrated in FIG. 5B, memory cells corresponding to at least two of the plurality of columns COL1 to COLi may be allocated to the count cell area CCA. In this case, each of the plurality of memory cells CC1 to CCj corresponding to the i-th column COLi may store count data of the corresponding row, and each of a plurality of memory cells PC1 to PCj corresponding to the (i-1)-th column COLi-1 may store parity data associated with the corresponding count data. The memory cells PC1 to PCj storing the parity data may be referred to as "parity cells". For example, the first parity cell PC1 may store parity data associated with the count data stored in the first count cell CC1, the second parity cell PC2 may store parity data associated with the count data stored in the second count cell CC2, and the j-th parity cell PCj may store parity data associated with the count data stored in the j-th count cell CCj.

The count data and/or the parity data for each of the plurality of rows ROW1 to ROWj may be managed in the count cell area CCA of the first bank 310_1 through the above method.

Meanwhile, in FIGS. 5A and 5B, the description is given as memory cells corresponding to one of the plurality of columns COL1 to COLi are allocated to count cells or parity cells. However, this is provided as an example. According to some implementations, memory cells corresponding to at least two of the plurality of columns COL1 to COLi may be allocated to count cells, and memory cells corresponding to at least two of the remaining columns among the plurality of columns COL1 to COLi may be allocated to parity cells.

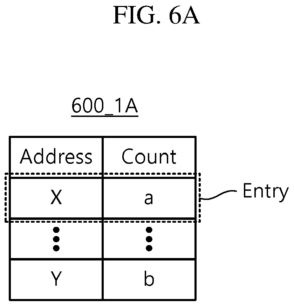

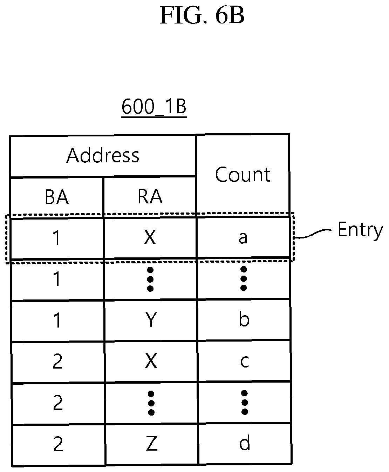

FIGS. 6A and 6B are diagrams showing an example of a register managing an address and count data of a row according to some implementations. In FIG. 6A, an example of a register corresponding to one bank is illustrated. In FIG. 6B, an example of a register corresponding to two banks is illustrated. Each of the first registers 600_1 A or 600_1B to be described with reference to FIGS. 6A and 6B may correspond, for example, to the first register 600_1 of FIGS. 1 and 3.

In FIG. 6A, the register may correspond to one bank and manage rows having relatively large count data from among a plurality of rows of the corresponding bank. For example, the first register 600_1A may correspond to the first bank 310_1 (in FIGS. 1 and 3). The first register 600_1A may be disposed in a peripheral area of the memory device 200 (in FIGS. 1 and 3) so as to be adjacent to the first bank 310_1.

The first register 600_1A may include at least one entry. Each entry may be formed of an address and count data of a corresponding row. For example, when a row corresponding to address "X" from among the plurality of rows of the first bank 310_1 is managed by the first register 600_1A, the address (i.e., "X") and count data (i.e., "a") of the corresponding row may constitute one entry of the first register 600_1A.

The number of entries of the first register 600_1A may be less than the number of rows of the first bank 310_1. In other words, the number of rows which are managed in the first register 600_1A may be less than the number of rows of the first bank 310_1.

In some implementations, the first register 600_1A may store an address and count data associated with at least one row having relatively large count data from among the plurality of rows of the first bank 310_1. In other words, at least one row which is managed in the first register 600_1A may be a row having relatively large count data from among the plurality of rows of the first bank 310_1.

In FIG. 6B, the register 600_1B may correspond to a plurality of banks and may manage rows each having relatively large count data from among a plurality of rows of the corresponding banks. For example, the first register 600_1B may correspond to a first bank and a second bank. In this case, the first register 600_1B may be disposed in a peripheral area of the memory device 200 so as to be adjacent to the first bank and the second bank.

The first register 600_1B may include at least one entry. Each entry may be formed of a bank address BA, the row address RA, and count data. For example, it is assumed that the bank address BA of the first bank is "1" and a row corresponding to the row address RA of "X" from among the plurality of rows of the first bank is managed by the first register 600_1B. In this case, a bank address (i.e., "1"), a row address (i.e., "X"), and count data (i.e., "a") of the corresponding row may constitute one entry of the first register 600_1B.

In some implementations, the first register 600_1B may store an address and count data associated with at least one row having relatively large count data from among the plurality of rows of the first bank and/or the second bank. In other words, at least one row which is managed in the first register 600_1B may be a row having relatively large count data from among the plurality of rows of the first bank and/or the second bank.

As described with reference to FIGS. 6A and 6B, the first register 600_1A and 600_1B may correspond to at least one bank and may store an address and count data associated with at least one row having relatively large count data from among a plurality of rows included in the corresponding bank. Accordingly, in the row hammer refresh operation, the memory device 200 may effectively perform the row hammer refresh operation based on information of a row managed in the register.

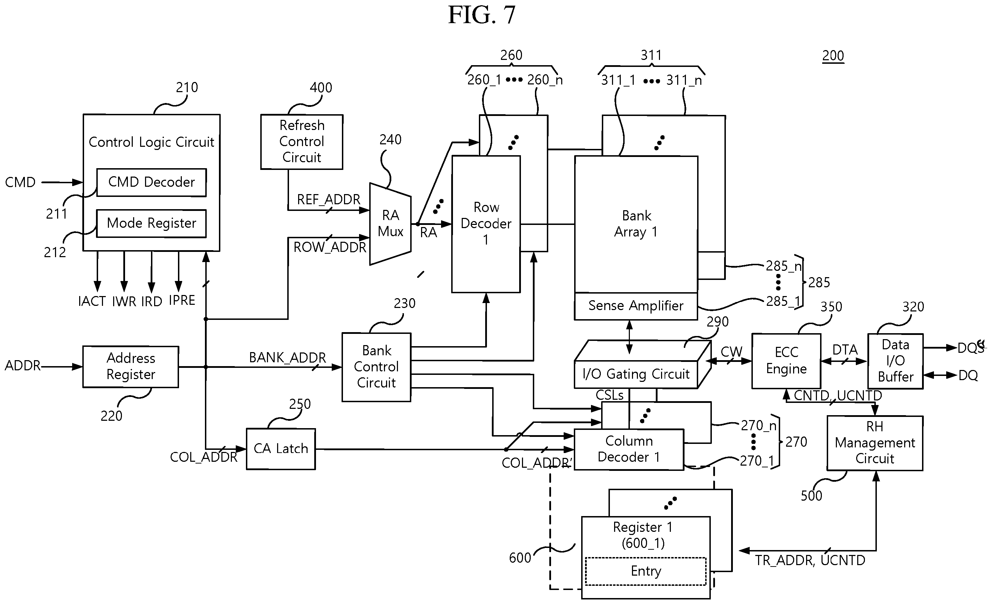

FIG. 7 is a block diagram illustrating an example of a memory device according to some implementations. In FIG. 7, the memory device 200 may correspond to the memory device 200 of FIGS. 1 and 3.

In FIG. 7, the memory device memory device 200 may include a control logic circuit 210, an address register 220, bank control circuit 230, a refresh control circuit 400, a row address multiplexer 240, a column address latch 250, a row decoder 260, a column decoder 270, a bank array group 311, a sense amplifier unit 285, an input/output gating circuit 290, an ECC engine 350, a data input/output buffer 320, the row hammer management circuit 500, and the register group 600.

The bank array group 311 may include the plurality of bank arrays 311_1 to 311_n. Each of the plurality of bank arrays 311_1 to 311_n may include a plurality of memory cells. For example, each of the plurality of memory cells may be formed at an intersection of a corresponding word line and a corresponding bit line.

The row decoder 260 may include a plurality of sub-row decoders 260_1 to 260_n. Each of the plurality of sub-row decoders 260_1 to 260_n may be connected to the corresponding bank array among the plurality of bank arrays 311_1 to 311_n.

The sense amplifier unit 285 may include a plurality of sense amplifiers 285_1 to 285_n. Each of the plurality of sense amplifiers 285_1 to 285_n may be connected to the corresponding bank array among the plurality of bank arrays 311_1 to 311_n.

The column decoder 270 may include a plurality of sub-column decoders 270_1 to 270_n. Each of the plurality of sub-column decoders 270_1 to 270_n may be connected to the corresponding bank array among the plurality of bank arrays 311_1 to 311_n through the corresponding sense amplifier.

The plurality of bank arrays 311_1 to 311_n, the plurality of sense amplifiers 285_1 to 285_n, the plurality of sub-column decoders 270_1 to 270_n, and the plurality of sub-row decoders 260_1 to 260_n may constitute a plurality of banks. For example, the first bank array 311_1, the first sense amplifier 285_1, the first sub-column decoder 270_1, and the first sub-row decoder 260_1 may constitute the first bank.

The address register 220 may receive an address ADDR including a bank address BANK_ADDR, a row address ROW ADDR, and a column address COL_ADDR from the memory controller 100. The address register 220 may provide the received bank address BANK_ADDR to the bank control circuit 230, may provide the received row address ROW_ADDR to the row address multiplexer 240, and may provide the received column address COL_ADDR to the column address latch 250. Also, the address register 220 may provide the bank address BANK_ADDR and the row address ROW_ADDR to the row hammer management circuit 500.

The bank control circuit 230 may generate bank control signals in response to the bank address BANK_ADDR. For example, a sub-row decoder corresponding to the bank address BANK_ADDR from among the plurality of sub-row decoders 260_1 to 260_n may be activated in response to the bank control signals. A sub-column decoder corresponding to the bank address BANK_ADDR from among the plurality of sub-column decoders 270_1 to 270_n may be activated in response to the bank control signals.

The row address multiplexer 240 may receive the row address ROW_ADDR from the address register 220 and may receive a refresh row address REF _ADDR from the refresh control circuit 400. The row address multiplexer 240 may selectively output the row address ROW_ADDR or the refresh row address REF_ADDR as the row address RA. The row address RA output from the row address multiplexer 240 may be applied to each of the plurality of sub-row decoders 260_1 to 260_n.

In response to refresh signals from the control logic circuit 210, in a normal refresh mode, the refresh control circuit 400 may sequentially increase or decrease the refresh row address REF ADDR.

The refresh control circuit 400 may receive a hammer address HADDR in a row hammer refresh mode. Based on the hammer address HADDR, the refresh control circuit 400 may output, as the refresh row address REF_ADDR, addresses of neighboring memory cell rows adjacent to an aggressor memory cell row.

A sub-row decoder selected by the bank control circuit 230 from among the plurality of sub-row decoders 260_1 to 260_n may activate a word line corresponding to the row address RA output from the row address multiplexer 240. For example, the selected sub-row decoder may apply a word line driving voltage to the word line corresponding to a row address.

The column address latch 250 may receive the column address COL_ADDR from the address register 220 and may temporarily store the received column address COL_ADDR. Also, for example, in a burst mode, the column address latch 250 may sequentially increase the received column address COL_ADDR. The column address latch 250 may apply a temporarily stored or sequentially increased column address COL_ADDR' to each of the plurality of sub-column decoders 270_1 to 270_n.

A sub-column decoder activated by the bank control circuit 230 from among the plurality of sub-column decoders 270_1 to 270_n may activate a sense amplifier corresponding to the bank address BANK_ADDR and the column address COL_ADDR through the input/output gating circuit 290.

The input/output gating circuit 290 may include circuits gating input/output data. Also, the input/output gating circuit 290 may include data latches for storing codewords output from the plurality of bank arrays 311_1 to 311_n and write drivers for writing data in the plurality of bank arrays 311_1 to 311_n.

In some implementations, in the read operation, a codeword CW read from a bank array selected from the plurality of bank arrays 311_1 to 311_n may be sensed by a sense amplifier corresponding to the selected bank array and may be stored in the data latches of the input/output gating circuit 290. Also, ECC decoding for the codeword CW stored in the data latches may be performed by the ECC engine 350 so as to be provided to the data input/output buffer 320 as data DTA. The data input/output buffer 320 may generate a data signal DQ based on the data DTA and may provide the data signal DQ to the memory controller 100 together with a strobe signal DQS.

In some implementations, in the write operation, the data DTA to be written in a bank array selected from the plurality of bank arrays 311_1 to 311_n may be received by the data input/output buffer 320 as the data signal DQ. The data input/output buffer 320 may convert the data signal DQ into the data DTA so as to be provided to the ECC engine 350. The ECC engine 350 may generate parity bits (or parity data) based on the data DTA and may provide the input/output gating circuit 290 with the codeword CW including the data DTA and the parity bits. The input/output gating circuit 290 may write the codeword CW in the selected bank array.

In the write operation, the data input/output buffer 320 may convert the data signal DQ into the data DTA so as to be provided to the ECC engine 350. In the read operation, the data input/output buffer 320 may convert the data DTA provided from the ECC engine 350 into the data signal DQ.

In the write operation, the ECC engine 350 may perform ECC encoding for the data DTA. In the read operation, the ECC engine 350 may perform ECC decoding for the codeword CW.

Also, the ECC engine 350 may perform ECC encoding and ECC decoding for count data CNTD provided from the row hammer management circuit 500.

The control logic circuit 210 may control the operation of the memory device 200. For example, the control logic circuit 210 may generate control signals such that the memory device 200 performs the write operation, the read operation, the normal refresh operation, and the row hammer refresh operation. The control logic circuit 210 may include a command decoder 211 which decodes a command CMD received from the memory controller 100 and a mode register set (MRS) 212 for setting an operation mode of the memory device 200.

The command decoder 211 may decode the command CMD to generate internal command signals, such as an internal active signal IACT, an internal precharge signal IPRE, an internal read signal IRD, and an internal write signal IWR. Also, the command decoder 211 may generate control signals corresponding to the command CMD by decoding a chip select signal, a command/address signal, etc.

In some implementations, the row hammer management circuit 500 may receive the count data CNTD from the ECC engine 350. The row hammer management circuit 500 may modify the count data CNTD and may again provide modified count data UCNTD to the ECC engine 350.

For example, when the active command for a target row is applied, the count data CNTD stored in the count cell of the target row and the parity data stored in the parity cell of the target row may be provided to the ECC engine 350. The ECC engine 350 may perform the ECC decoding operation on the count data CNTD by using the parity data and may transfer the count data CNTD to the row hammer management circuit 500.

The row hammer management circuit 500 may generate the modified count data UCNTD by increasing the count data CNTD as much as "1" or increasing the count data CNTD as much as "k" (k being a natural number of 2 or more) in consideration of the activation time of the target row. The row hammer management circuit 500 may provide the modified count data UCNTD to the ECC engine 350, and the ECC engine 350 may generate the parity data through the ECC encoding operation on the modified count data UCNTD. The modified count data UCNTD and the parity data associated with the modified count data UCNTD may be stored in the count cell and the parity cell of the target row.

In some implementations, the row hammer management circuit 500 may transmit an address TR_ADDR and the modified count data UCNTD of the target row to the register group 600. The row hammer management circuit 500 may selectively update the register group 600 by using the address TR_ADDR and the modified count data UCNTD of the target row.

For example, the row hammer management circuit 500 may select a register, which corresponds to a bank to which the target row belongs, from among registers of the register group 600. The row hammer management circuit 500 may update the register based on a comparison result of an address and/or count data managed in the selected register with the address TR_ADDR and/or the modified count data UCNTD of the target row. For example, when at least one of pieces of count data of entries of the register is smaller than the modified count data UCNTD of the target row, the row hammer management circuit 500 may replace the entry of the register corresponding to the minimum count data with the address TR_ADDR of the target row and the modified count data UCNTD.

As described above, as the memory device 200 manages an address and count data associated with a row having relatively large count data from among a plurality of rows through the register group 600, the memory device 200 may manage the risk of occurrence of the per row hammer phenomenon to be an appropriate level or lower and may effectively prevent the row hammer phenomenon.

In FIG. 7, the description is given as the memory device 200 includes the ECC engine 350. However, this is provided as an example. According to some implementations, the memory device 200 may not include an ECC engine. In this case, the row hammer management circuit 500 may read the count data of the count cell of the target row through the input/output gating circuit 290, may generate modified count data by increasing the read count data as much as "1", and may again write the modified count data in the count cell of the target row through the input/output gating circuit 290.

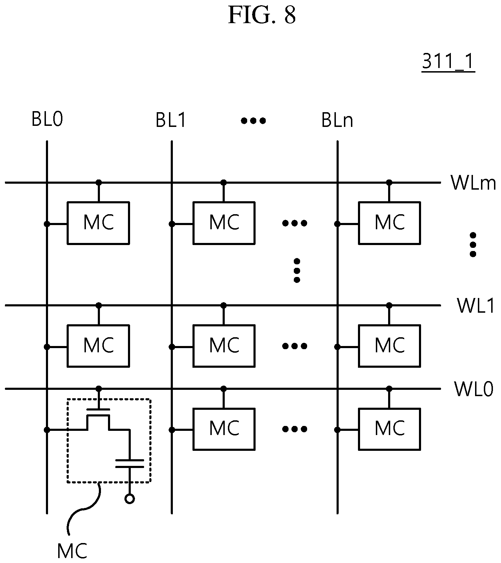

FIG. 8 is a diagram illustrating an example of a bank array according to some implementations. The bank array 311_1 of FIG. 8 may correspond, for example, to the first bank array 311_1 of FIG. 7.

In FIG. 8, the first bank array 311_1 may include a plurality of word lines WL0 to WLm, a plurality of bit lines BL0 to BLn, and a plurality of memory cells MC disposed at intersections of the word lines WL0 to WLm and the bit lines BL0 to BLn.

In some implementations, each of the memory cells MC may be a DRAM cell. For example, each of the memory cells MC may include a cell transistor connected to a word line and a bit line and a cell capacitor connected to the cell transistor.

In the present disclosure, a word line extending in a row direction may be referred to as a "row" of the first bank array 311_1. When the access of a specific row is focused, the row, the access of which is focused, may be referred to as an "aggressor row". Also, a row adjacent to the aggressor row may be referred to as a "victim row". For example, when the access of a first word line is focused, the first row corresponding to the first word line may be referred to as an "aggressor row", and the 0-th and second rows adjacent to the first row may be referred to as "victim rows". However, this is provided as an example. According to some implementations, a victim row may be variously determined. For example, when the access of a second word line is focused, the second row corresponding to the second word line may be referred to as an "aggressor row", and the 0-th, first, third, and fourth rows adjacent to the second row may be referred to as "victim rows".

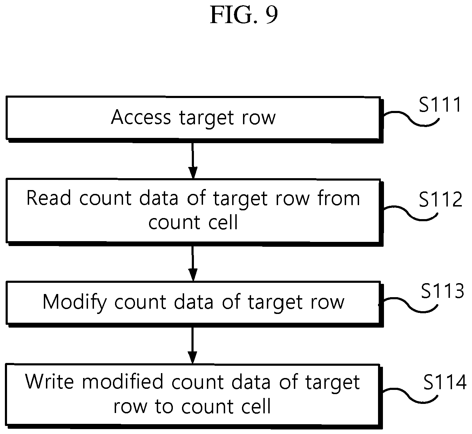

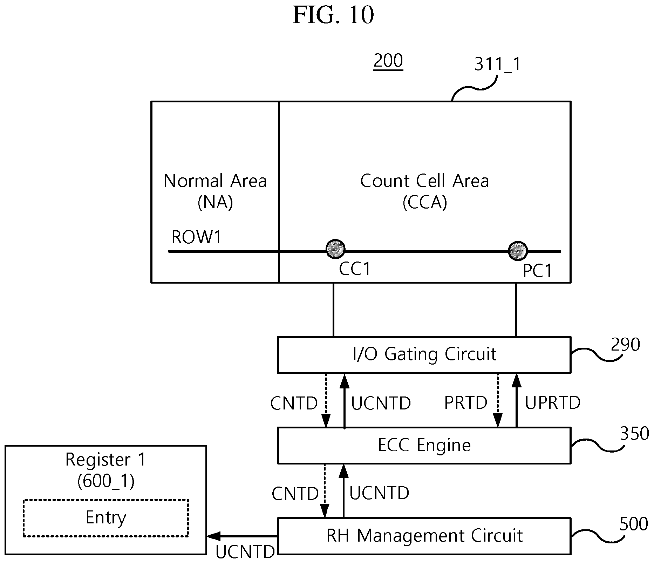

FIGS. 9 and 10 are diagrams showing examples of an operation of a memory device which manages count data through a count cell area according to some implementations. In detail, an example of a flowchart describing the RMW operation is illustrated in FIG.. An example of a memory device which performs the RMW operation is illustrated in FIG. 10. The memory device illustrated in FIGS. 9 and 10 may correspond to the memory device illustrated in FIGS. 1 and 3. For convenience of description, it is assumed that the count cell area CCA includes a count cell and a parity cell and a target row is the first row ROW1 of the first bank array 311_1.

In FIGS. 9 and 10, in operation S111, the memory device may receive an access request for the target row. For example, the memory device 200 (in FIG. 3) may receive an address and an active command, which are associated with the first row ROW1 being the target row, from the memory controller 100 (in FIG. 3). Alternatively, the memory device 200 may receive an address and a precharge command, which are associated with the first row ROW1 being the target row, from the memory controller 100.

In operation S112, the memory device may read count data of the target row, which are stored in the count cell. For example, as illustrated in FIG. 10, the count cell area CCA of the first bank array 311_1 may include the first count cell CC1 and the first parity cell PC1. In this case, the count data CNTD stored in the first count cell CC1 and parity data PRTD stored in the first parity cell PC1 may be provided to the ECC engine 350 through the input/output gating circuit 290. The ECC engine 350 may perform ECC decoding for the count data CNTD by using the parity data PRTD. Afterwards, the ECC engine 350 may transfer the error-corrected count data CNTD to the row hammer management circuit 500.

In operation S 113, the memory device may modify the count data of the target row. For example, as illustrated in FIG. 10, the row hammer management circuit 500 may generate the modified count data UCNTD by adding "+1" to the count data CNTD. However, this is provided as an example. According to some implementations, the row hammer management circuit 500 may generate the modified count data UCNTD by changing the count data CNTD in various manners.

In operation S114, the memory device may again store the modified count data in the count cell. For example, as illustrated in FIG. 10, the row hammer management circuit 500 may transfer the modified count data UCNTD to the ECC engine 350. The ECC engine 350 may generate updated parity data UPRTD through the ECC encoding operation. The modified count data UCNTD and the modified parity data UPRTD may be respectively stored in the first count cell CC1 and the first parity cell PC1 through the input/output gating circuit 290.

According to some implementations, the memory device 200 may accurately manage count data for each row through the count cell area CCA.

Meanwhile, as illustrated in FIG. 10, the row hammer management circuit 500 may transfer the modified count data UCNTD to the first register 600_1 corresponding to the first bank array 311_1. For example, when count data of an entry of the first register 600_1 are smaller than the modified count data UCNTD thus transferred, the corresponding entry of the first register 600_1 may be replaced with the address and the modified count data UCNTD of the target row. Accordingly, an address and count data of a row having relatively large count data from among a plurality of rows of managed in the count cell area CCA may be managed by using the register. Accordingly, the row hammer refresh operation is effectively performed.

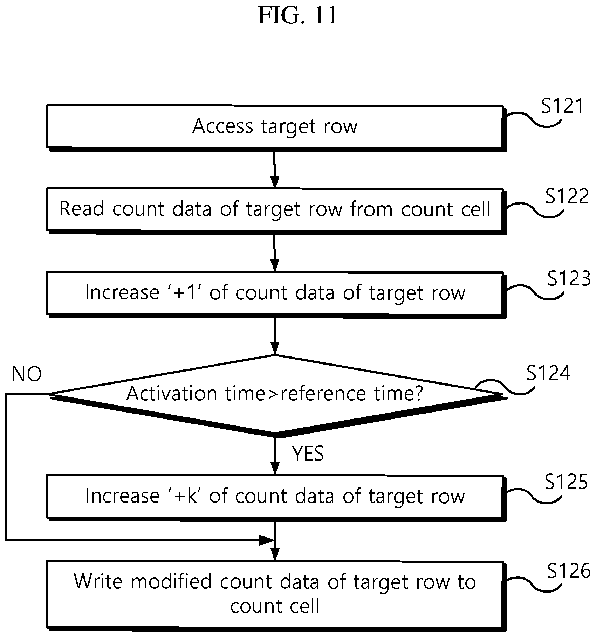

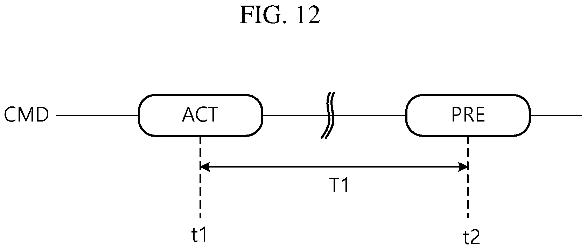

FIGS. 11 and 12 are diagrams showing examples of an operation of a memory device which manages count data through a count cell area according to some implementations. In detail, an example flowchart describing the RMW operation is illustrated in FIG. 11. A diagram showing an example of an activation time of a target row is illustrated in FIG. 12. An operation of the memory device of FIGS. 11 and 12 is similar to that of FIGS. 9 and 10, and additional description will be omitted to avoid redundancy.

In operation S121, the memory device may receive the access request for the target row.

In operation S122, the memory device may read the count data of the target row, which are stored in the count cell.

In operation S123, the memory device may modify the count data of the target row in consideration of the number of times of activation of the target row. For example, the memory device may modify the count data by increasing the count data of the target row as much as "+1".

In operation S124, the memory device may determine whether the activation time of the target row is larger than the reference time.

For example, as illustrated in FIG. 12, a time T1 from a first point in time t1 when an active command ACT is received to a second point in time t2 when a precharge command PRE is received may be defined as the activation time of the target row. As the activation time becomes longer, the probability that data of a victim row are lost due to the PGE phenomenon may increase. To suppress the PGE phenomenon, the memory device may determine whether the activation time T1 of the target row is larger than the reference time.

When the activation time of the target row is larger than the reference time, operation S125 may be performed. In operation S125, the memory device may additionally modify the count data of the target row in consideration of the activation time of the target row. For example, the memory device may modify the count data by additionally increasing the count data of the target row as much as "+k" (k being a natural number of 1 or more).

When the activation time of the target row is smaller than the reference time, operation S126 may be performed. In operation S126, the memory device may again store the modified count data in the count cell.

According to the above description, the memory device 200 may manage count data for each row through the count cell area CCA. In addition, the memory device 200 may modify the count data in consideration of the activation time, in addition to the number of times of access of each of the plurality of rows. Accordingly, the probability that the data stored at the victim row are lost may further decrease.

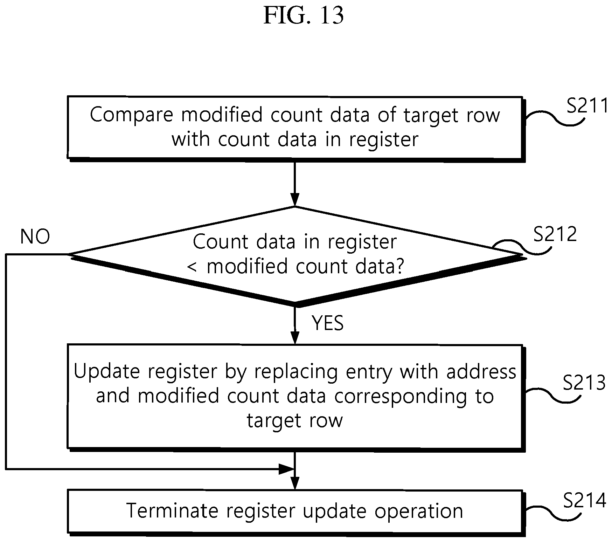

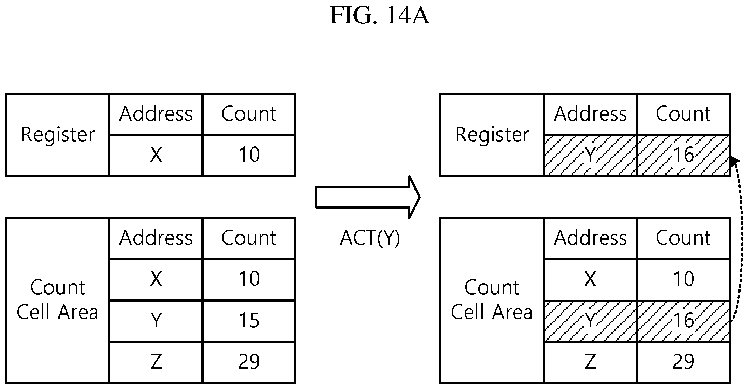

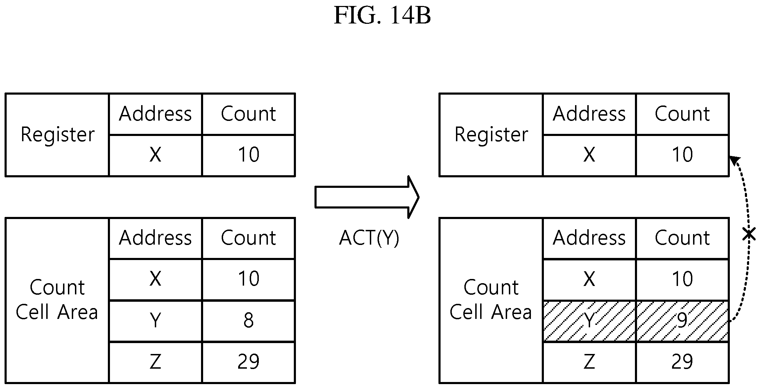

FIGS. 13, 14A, and 14B are diagrams showing examples of an operation of a memory device which manages relatively large count data by using a register according to some implementations. In detail, an example flowchart describing a register update operation according to some implementations is illustrated in FIG. 13. The case where modified count data are larger than count data of the register is illustrated in FIG. 14A, as an example. The case where modified count data are smaller than count data of the register is illustrated in FIG. 14B, as an example. For convenience of description, in FIGS. 14A and 14B, it is presumed that the register manages one entry, and that a target row corresponding to address "Y" is activated.

In FIGS. 13, 14A, and 14B, in operation S211, the memory device may compare the modified count data of the target row with count data managed in the register.

In operation S212, the memory device may determine whether the count data of the register are smaller than the modified count data of the target row.

When the count data of the register are smaller than the modified count data of the target row, operation S213 may be performed. In operation S213, the memory device may update the register by replacing the entry of the register, which has a count smaller than the modified count data, with the address and the modified count data of the target row.

In some implementations, the description will be given in detail with reference to FIG. 14A. It is assumed that rows corresponding to address "X", address "Y", and address "Z" are managed in the count cell area and count data of address "X", address "Y", and address "Z" are "10", "15", and "29", respectively. Also, it is presumed that the row corresponding to address "X" is managed in the register and the count data of the row of address "X" are "10". Afterwards, it is presumed that an active command ACT(Y) for the target row is received and an address of a target row is "Y".

In this case, the memory device may modify the count data of the row corresponding to address "Y" from "15" to "16" through the RMW operation. Afterwards, the memory device may determine whether the count data of the entry managed in the register are smaller than the modified count data. Because the count data (i.e., "10") of the register are smaller than the modified count data (i.e., "16"), the address and the count data of the entry of the register may be replaced with "Y" being the address of the target row and "16" being the modified count data.

When the count data of the register are larger than the modified count data of the target row, operation S213 may be omitted.

In some implementations, the description will be given in detail with reference to FIG. 14B. Unlike FIG. 14A, it is presumed that the count data of address "Y" managed in the count cell area are "8". Afterwards, it is presumed that an active command ACT(Y) for the target row is received and an address of a target row is "Y".

In this case, the memory device may modify the count data of the row corresponding to address "Y" from "8 to "9" through the RMW operation. Afterwards, the memory device may determine whether the count data of the entry managed in the register are smaller than the modified count data. Because the count data (i.e., "10") of the register are larger than the modified count data (i.e., "9"), the entry of the register may not be replaced, that is, may be maintained without modification.

In operation S214, the register update operation may be terminated.

As described above, the memory device may manage a row with relatively large count data by using the register, based on a comparison result of modified count data and count data managed in the register. Accordingly, the row hammer refresh operation may be effectively performed.

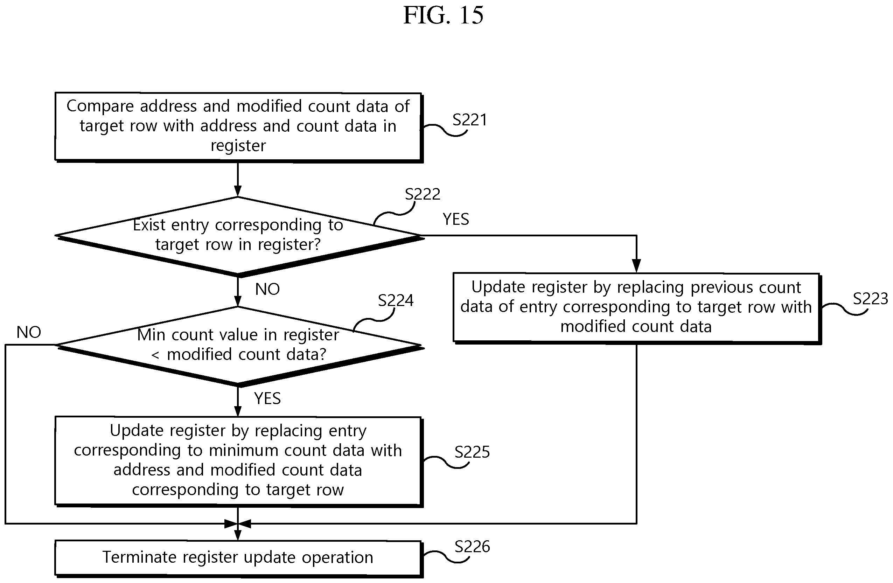

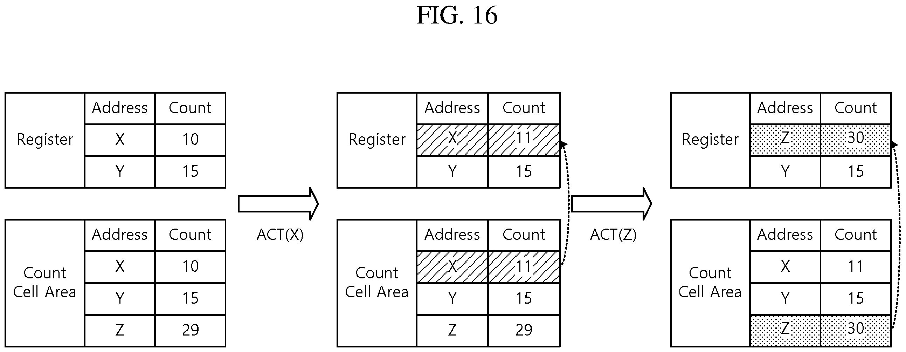

FIGS. 15 and 16 are diagrams showing examples of an operation of a memory device which manages relatively large count data by using a register according to some implementations. In detail, an example flowchart describing the register update operation according to some implementations is illustrated in FIG. 15. The case where an address corresponding to modified count data is already present in an entry of the register and the case where an address corresponding to modified count data is absent from an entry of the register are illustrated in FIG. 16 as an example.

For convenience of description, in FIG. 15, it is presumed that the register manages two entries. As in the above description given with reference to FIG. 14A. It is presumed that rows corresponding to address "X", address "Y", and address "Z" are managed in the count cell area and count data of address "X", address "Y", and address "Z" are "10", "15", and "29", respectively. Also, it is it is presumed that the rows corresponding to address "X" and address "Y" are managed in the register and the count data of the rows corresponding to address "X" and address "Y" are "10" and "15". Afterwards, it is presumed that a target row corresponding to address "X" is activated and a target row corresponding to address "Z" is activated. An operation of the memory device of FIGS. 15 and 16 is similar to that of FIGS. 13 and 14, and additional description will be omitted to avoid redundancy.

In FIGS. 15 and 16, in operation S221, the memory device may compare an address and modified count data of the target row with an address and count data managed in the register.

In operation S222, the memory device may determine whether an entry corresponding to the target row is present in entries managed in the register. When the entry corresponding to the target row is present in the entries managed in the register, operation S223 may be performed. When the entry corresponding to the target row is absent from the entries managed in the register, operation S224 may be performed.

In operation S223, the memory device may update the register by replacing previous count data of the target row managed in the entry of the register with the modified count data.

In some implementations, the description will be given in detail with reference to FIG. 16. It is presumed that an active command ACT(X) for the target row is received and an address of the target row is "X".

In this case, the memory device may modify the count data of the row corresponding to address "X" from "10 to "11" through the RMW operation. Afterwards, the memory device may determine whether address "X" is managed in the register. Because address "X" is managed in the register, the memory device may replace the count data of the register corresponding to address "X", that is, "10" being previous count data with "11" being the newly modified count data.

In operation S224, the memory device may determine whether the minimum count data among pieces of count data of the register are smaller than the modified count data of the target row.

When the minimum count data among the pieces of count data of the register are smaller than the modified count data of the target row, operation S225 may be performed. In operation S225, the memory device may update the register by replacing the entry of the register, which has the minimum count data, with the address and the modified count data of the target row.

In some implementations, the description will be given in detail with reference to FIG. 16. It is presumed that an active command ACT(Z) for the target row is received and an address of the target row is "Z". In this case, the memory device may modify the count data of the row corresponding to address "Z" from "29 to "30" through the RMW operation. Afterwards, the memory device may determine whether the minimum count data among pieces of count data of entries managed in the register are smaller than the modified count data. Because the minimum count data (i.e., ‴11") of the register are smaller than the modified count data (i.e., "30"), address "X" of the entry of the register and the count data of "11" corresponding to address "X" may be replaced with address "Z" of the target row and the count data of "30" corresponding to address "Z". When the minimum count data among the pieces of count data of the register are larger than the modified count data of the target row, the register update operation may be omitted.

In operation S226, the register update operation may be terminated.

As described above, the memory device may update previous count data when an address corresponding to modified count data is already present in entries of the register. When the address corresponding to the modified count data is absent from the entries of the register, the memory device may replace an entry of the register corresponding to the minimum count data with an address and modified count data of a target row. As the memory device manages a row with relatively large count data by using the register, the row hammer refresh operation may be effectively performed.

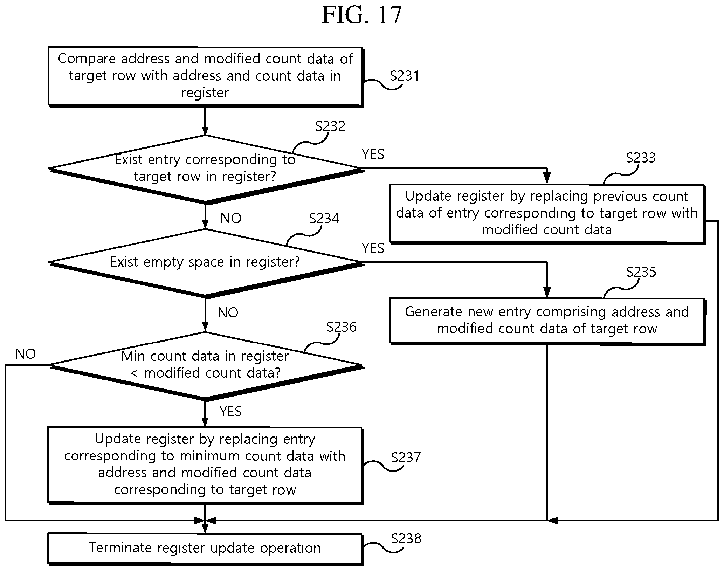

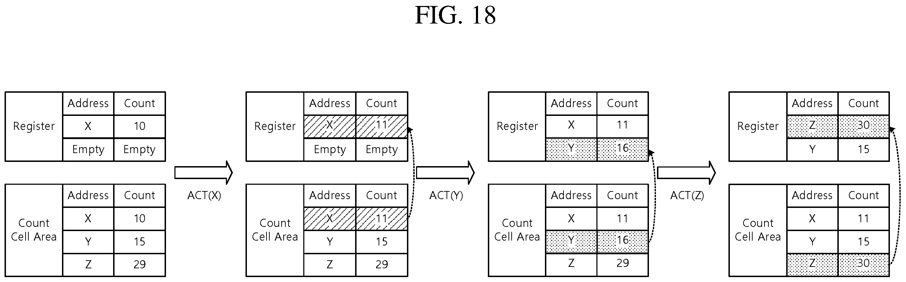

FIGS. 17 and 18 are diagrams showing examples of an operation of a memory device which manages relatively large count data by using a register according to some implementations. In detail, an example flowchart describing the register update operation is illustrated in FIG. 17. The case where an empty space is present in the register and the case where an empty space is absent from the register are illustrated in FIG. 18, as an example.

For convenience of description, in FIG. 18, it is presumed that the register manages two entries. As in the above description given with reference to FIG. 14A. It is presumed that rows corresponding to address "X", address "Y", and address "Z" are managed in the count cell area and count data of address "X", address "Y", and address "Z" are "10", "15", and "29", respectively. Also, it is presumed that the row corresponding to address "X" is managed in the register. Afterwards, it is presumed that the rows corresponding to address "X", address "Y", and address "Z" are sequentially activated. An operation of the memory device of FIGS. 17 and 18 is similar to that of FIGS. 15 and 16, and additional description will be omitted to avoid redundancy.

In FIGS. 17 and 18, in operation S231, the memory device may compare an address and modified count data of the target row with an address and count data managed in the register.

In operation S232, the memory device may determine whether an entry corresponding to the target row is present in entries managed in the register.

When the entry corresponding to the target row is present in the entries managed in the register, operation S233 may be performed. In operation S233, the memory device may update the register by replacing previous count data of the target row managed in the entry of the register with the modified count data.

In some implementations, the description will be given in detail with reference to FIG. 18. It is presumed that the active command ACT(X) for the target row is received and an address of the target row is "X". In this case, the memory device may modify the count data of the row corresponding to address "X" from "10 to "11" through the RMW operation. Afterwards, the memory device may determine whether address "X" is managed in the register. Because address "X" is managed in the register, the memory device may replace the count data of the register corresponding to address "X", that is, "10" being previous count data with "11" being the modified count data.

When the entry corresponding to the target row is absent from the entries managed in the register, operation S234 may be performed. In operation S234, the memory device may determine whether an empty space is present in the register. When an empty space is present in the register, operation S235 may be performed. When an empty space is absent from the register, operation S236 may be performed.

In operation S235, the memory device may generate a new entry including the address and the modified count data of the target row and may store the new entry in the register.

In some implementations, the description will be given in detail with reference to FIG. 18. It is assumed that the active command ACT(Y) for the target row is received and an address of the target row is "Y". In this case, the memory device may modify the count data of the row corresponding to address "Y" from "15" to "16" through the RMW operation. Afterwards, the memory device may determine whether address "Y" is managed in the register. When address "Y" is not managed in the register, the memory device may determine whether an empty space is present in the register. Because an empty space is present in the register, the memory device may generate a new entry including address "Y" and "16" being count data corresponding to address "Y", so as to be stored in the register.

In operation S236, the memory device may determine whether the minimum count data among pieces of count data of the register are smaller than the modified count data of the target row.

When the minimum count data among the pieces of count data of the register are smaller than the modified count data of the target row, operation S237 may be performed.

In operation S237, the memory device may update the register by replacing the entry of the register, which has the minimum count data, with the address and the modified count data of the target row.

In some implementations, the description will be given in detail with reference to FIG. 18. It is presumed that the active command ACT(Z) for the target row is received and an address of the target row is "Z". In this case, the memory device may modify the count data of the row corresponding to address "Z" from "29 to "30" through the RMW operation. Afterwards, the memory device may determine whether the minimum count data among pieces of count data of entries managed in the register are smaller than the modified count data, may replace address "X" of the entry of the register with "Z" being the address of the target row, and may replace "11" being the count data of address "X" with "30" being the modified count data of the target row.

When the minimum count data among the pieces of count data of the register are larger than the modified count data of the target row, the register update operation may be omitted.

In operation S238, the register update operation may be terminated.

As described above, the memory device may update previous count data when an address corresponding to modified count data is already present in entries of the register. When an address corresponding to the modified count data is absent from entries of the register and an empty space is present in the register, the memory device may generate an entry corresponding to the target row. When the address corresponding to the modified count data is absent from the entries of the register and an empty space is absent from the register, the memory device may replace an entry of the register corresponding to the minimum count data with the address and the modified count data of the target row.

As the memory device manages a row with relatively large count data by using the register, the row hammer refresh operation may be effectively performed.

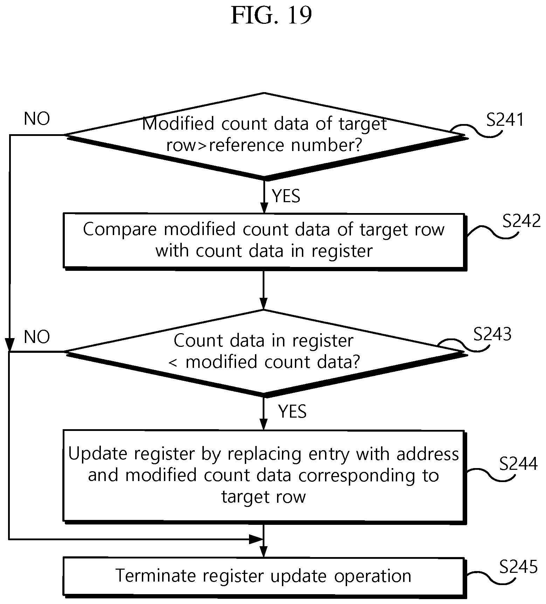

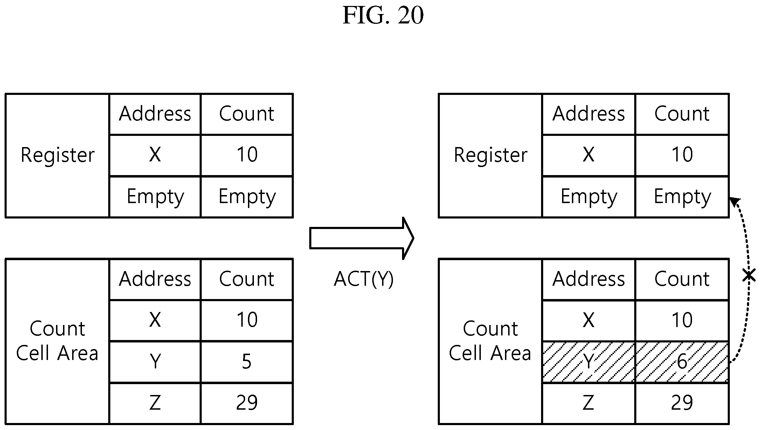

FIGS. 19 and 20 are diagrams showing examples of an operation of a memory device which manages relatively large count data by using a register according to some implementations. In detail, an example flowchart describing the register update operation is illustrated in FIG. 19. The case where modified count data are smaller than a reference number is illustrated in FIG. 20, as an example.

For convenience of description, in FIG. 20, it is presumed that the register manages two entries. Also, it is presumed that rows corresponding to address "X", address "Y", and address "Z" are managed in the count cell area and count data of address "X", address "Y", and address "Z" are "10", "5", and "29", respectively. Also, it is presumed that the row corresponding to address "X" is managed in the register. Afterwards, it is presumed that a target row corresponding to address "Y" is activated. An operation of the memory device of FIGS. 19 and 20 is similar to that of FIGS. 13 and 14, and additional description will be omitted to avoid redundancy.

In FIGS. 19 and 20, in operation S241, the memory device may determine whether modified count data of the target row are larger than the reference number. When the modified count data of the target row are smaller than the reference number, the register update operation may be omitted.

In some implementations, the description will be given in detail with reference to FIG. 20. It is presumed that the active command ACT(Y) for the target row is received and an address of the target row is "Y". Also, it is presumed that the reference number is "10".

In this case, the memory device may modify the count data of the row corresponding to address "Y" from "5" to "6" through the RMW operation. Afterwards, the memory device may determine whether the modified count data are larger than the reference number. Because the modified count data (i.e., "6") are smaller than the reference number (i.e., "10"), the memory device may omit the operation of updating the register by using the modified count data. In other words, the modified count data smaller than the reference number may not be managed by the register. Accordingly, the memory device may manage the row with the count data larger than the reference number by using the register.

Meanwhile, when the modified count data of the target row are larger than the reference number, operation S242 may be performed. In operation S242, the memory device may compare the modified count data of the target row with the count data managed in the register.

In operation S243, the memory device may determine whether the count data of the register are smaller than the modified count data of the target row.

When the count data of the register are smaller than the modified count data of the target row, the memory device may update the register by replacing the entry of the register, which has a count smaller than the modified count data, with the address and the modified count data of the target row (S244).

When the count data of the register are larger than the modified count data of the target row, the register update operation may be omitted.

In operation S245, the register update operation may be terminated.

As described above, the memory device may manage a row with count data larger than the reference number by using the register and may not manage a row with count data smaller than the reference number in the register. Also, the memory device may manage a row with relatively large count data by using the register, based on a comparison result of modified count data and count data managed in the register. Accordingly, the row hammer refresh operation may be effectively performed.

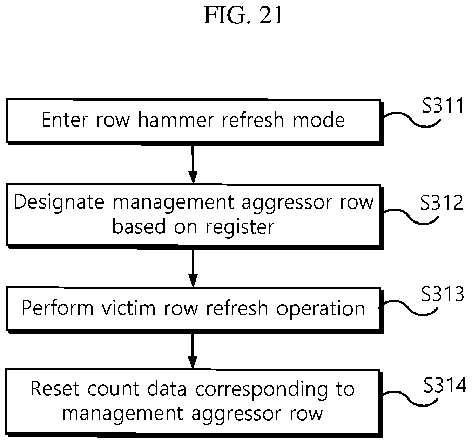

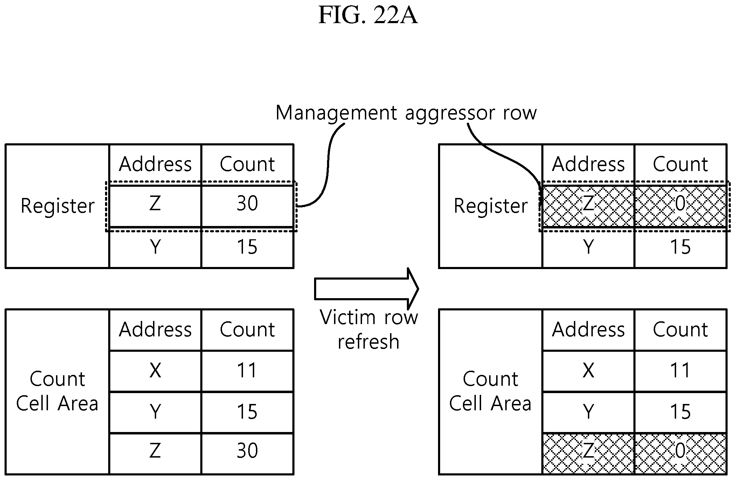

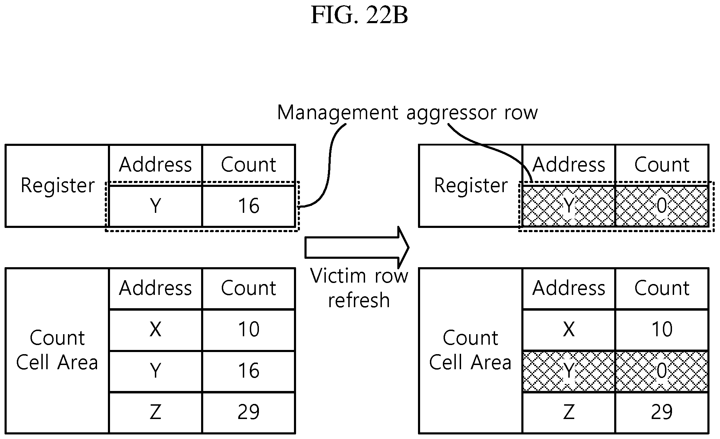

FIGS. 21, 22A, and 22B are diagrams showing an example of an operation of a memory device which performs a row hammer refresh operation based on information of a row managed in a register according to some implementations. In detail, an example flowchart of the row hammer refresh operation is illustrated in FIG. 21. An example in which the maximum count data managed in the count cell area is managed even in the register is illustrated in FIG. 22A. An example in which the maximum count data managed in the count cell area is not managed in the register is illustrated in FIG. 22B.

For convenience of description, it is presumed that rows managed in the register and the count cell area in FIG. 22A are the same as those in FIG. 18. Also, it is presumed that rows managed in the register and the count cell area in FIG. 22B are the same as those in FIG. 14A.

In FIG. 21, in operation S311, the memory device may enter the row hammer refresh mode. For example, the memory device may enter the row hammer refresh mode in response to an RFM command received from a memory controller. In some implementations, as another example, when the memory device is in the idle state or the background operation is performed, the memory device may enter the row hammer refresh mode. In some implementations, as another example, before or after the normal refresh operation is performed, the memory device may enter the row hammer refresh mode.

In operation S312, the memory device may designate a management aggressor row, based on information of a row managed in the register. For example, the memory device 200 may designate a row having the maximum count data from among rows managed in the register as a management aggressor row.

For example, in FIG. 22A, rows corresponding to address "Z" and address "Y" are managed in the register, count data of address "Z" are "30", and count data of address "Y" are "15". In this case, the memory device may designate the row, which has the maximum count data and corresponds to address "Z", from among the rows managed in the register as a management aggressor row.

In some implementations, for example, in FIG. 22B, only one row corresponding to address "Y" may be managed in the register. In this case, the memory device may designate the row corresponding to address "Y" managed in the register as a management aggressor row.

In operation S313, the memory device may perform the victim row refresh operation on a victim row. For example, the memory device may designate at least one row adjacent to the management aggressor row as a victim row and may perform the refresh operation on the victim row.

In this case, the victim row may be variously set. For example, as described with reference to FIG. 8, when the first row corresponding to the first word line is designated as a management aggressor row, the 0-th and second rows adjacent to the first row may be selected as a victim row. In some implementations, for example, when the second row corresponding to the second word line is designated as a management aggressor row, the 0-th, first, third, and fourth rows adjacent to the second row may be selected as a victim row.

In operation S314, the memory device may reset the count data corresponding to the management aggressor row. For example, in association with the management aggressor row, the memory device may reset both the count data of the count cell area and the count data of the register to "0".

For example, referring to FIG. 22A, the count data corresponding to address "Z" designated as the management aggressor row may be reset to "0" in both the count cell area and the register.

In some implementations, for example, in FIG. 22B, the count data corresponding to address "Y" designated as the management aggressor row may be reset to "0" in both the count cell area and the register.

Meanwhile, in FIG. 22B, a row having the maximum count data in the count cell area is the row corresponding to address "Z", but the row corresponding to address "Z" may not be managed in the register. This means that the row corresponding to address "Z" is not accessed any more during a given time from a current time point. Accordingly, the risk level at which the row hammer occurs at the row corresponding to address "Z" is not increased any more, that is, is continuously maintained. As a result, an upper bound of the per row hammer disturb may be set.

As described above, the memory device may manage a row having relatively large count data from among a plurality of rows by using the register and may perform the row hammer refresh operation based on row information of the register. Accordingly, the memory device may manage the risk of occurrence of the per row hammer phenomenon to be an appropriate level or lower. This may mean that the row hammer phenomenon is effectively prevented.

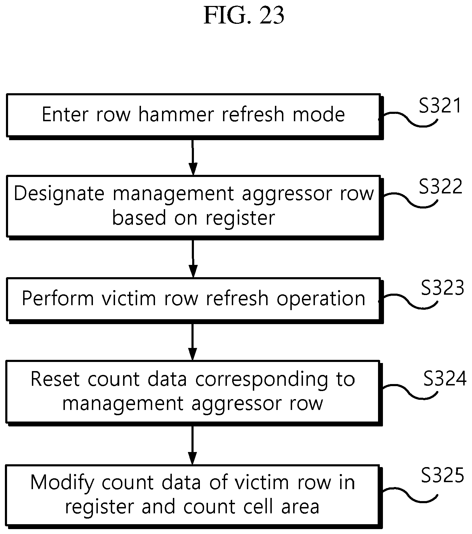

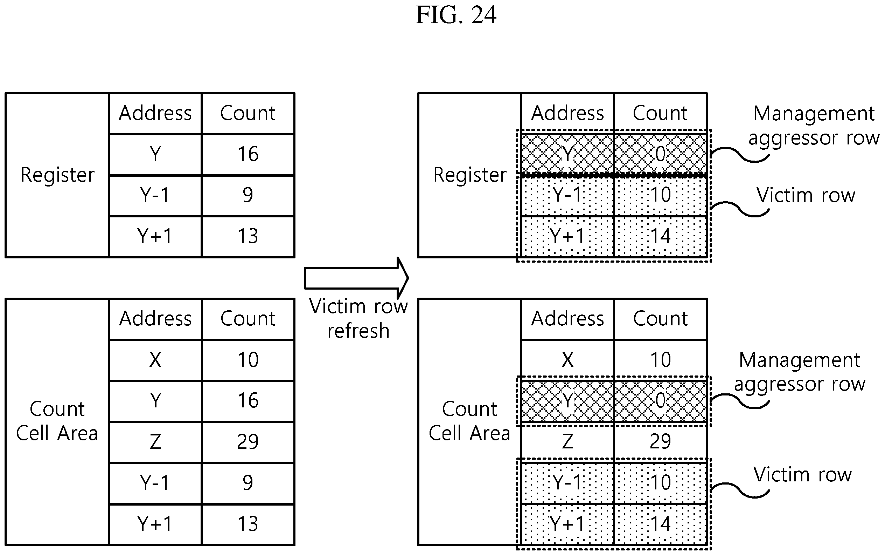

FIGS. 23 and 24 are diagrams showing an example of an operation of a memory device which performs a row hammer refresh operation based on information of a row managed in a register according to some implementations. In detail, an example flowchart of the row hammer refresh operation is illustrated in FIG. 23. An example in which count data of a victim row are modified is illustrated in FIG. 24.

For convenience of description, it is presumed that rows corresponding to address "X", address "Y", address "Z", address "Y-1", and address "Y+1" are managed in the count cell area and the rows corresponding to address "Y", address "Y-1", and address "Y+1" are managed in the register. Also, it is presumed that the rows corresponding to address "Y-1" and address "Y+1" are rows adjacent to the row corresponding to address "Y". The row hammer refresh operation to be described with reference to FIGS. 23 and 24 is similar to that described with reference to FIGS. 21 and 22, and additional description will be omitted to avoid redundancy.

In FIG. 23, in operation S321, the memory device may enter the row hammer refresh mode.

In operation S322, the memory device may designate a management aggressor row, based on information of a row managed in the register. For example, as illustrated in FIG. 24, the memory device may designate the row corresponding to address "Y" as a management aggressor row.

In operation S323, the memory device may perform the victim row refresh operation on a victim row. For example, the memory device may designate at least one row adjacent to the management aggressor row as a victim row and may perform the refresh operation on the victim row. For example, as illustrated in FIG. 24, the memory device may designate the row corresponding to address "Y-1" and the row corresponding to address "Y+1" as a victim row and may perform the refresh operation on the victim rows.

In operation S324, the memory device may reset the count data corresponding to the management aggressor row. For example, as illustrated in FIG. 24, the memory device may reset both the count cell area and the register to "0" in association with count data of the row corresponding to address "Y".

In operation S325, the memory device may modify count data of the victim rows.

For example, as illustrated in FIG. 24, the memory device may increase the count data of the row corresponding to address "Y-1" as much as "+1" and may increase the count data of the row corresponding to address "Y+1" as much as "+1".

The activation of the victim row may be performed prior to the victim row refresh operation. In other words, the access operation to the victim row is required for the victim row refresh operation. Accordingly, to manage the number of times of access of the victim row more accurately, the memory device may modify the count data of the victim row as much as "+1", as illustrated in FIG. 24.

As described above, the memory device may manage a row having relatively large count data from among a plurality of rows by using the register and may perform the row hammer refresh operation based on row information of the register. Accordingly, the memory device may manage the risk of occurrence of the per row hammer phenomenon to be an appropriate level or lower. This may mean that the row hammer phenomenon is effectively prevented. In addition, because the memory device considers the number of times of access in the victim row refresh operation, the memory device may manage count data more accurately.

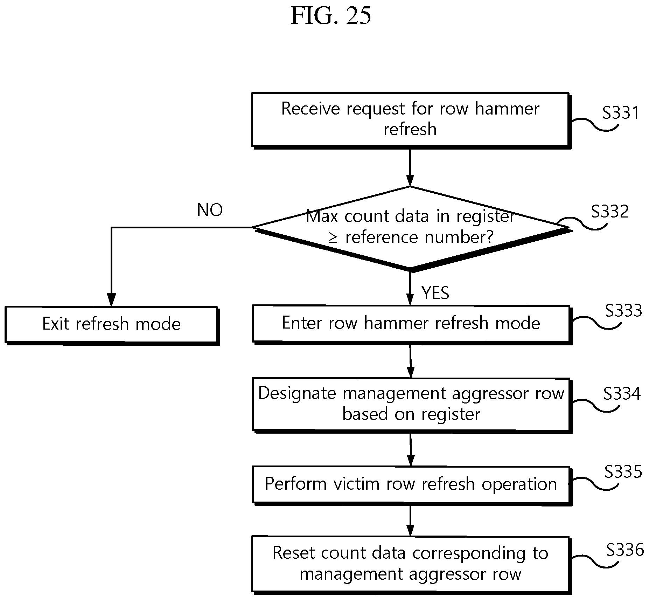

FIGS. 25 is a flowchart showing an example of an operation of a memory device which performs a row hammer refresh operation based on information of a row managed in a register according to some implementations. The row hammer refresh operation to be described with reference to FIG. 25 is similar to that described with reference to FIGS. 21 to 24, and additional description will be omitted to avoid redundancy.

In FIG. 25, in operation S331, the memory device may receive a row hammer refresh request. For example, the memory device may receive the RFM command from the memory controller.

In operation S332, the memory device may determine whether the maximum count data managed in the register is larger than or equal to the reference number.

When the maximum count data managed in the register is larger than or equal to the reference number, the memory device may enter the row hammer refresh mode (S333).

Afterwards, in operation S334, the memory device may designate a management aggressor row, based on information of a row managed in the register.

In operation S335, the memory device may perform the victim row refresh operation on a victim row.

In operation S326, the memory device may reset the count data corresponding to the management aggressor row.

When the maximum count data managed in the register is smaller than the reference number, the memory device may not enter the row hammer refresh mode. In other words, the memory device may determine that the risk of occurrence of the row hammer is low and may omit the row hammer refresh operation.

As described above, the memory device may perform the row hammer refresh operation only when the maximum count data managed in the register for an effective row hammer operation is larger than or equal to the reference number. Also, the memory device may manage a row having relatively large count data from among a plurality of rows by using the register and may perform the row hammer refresh operation based on row information of the register. Accordingly, the memory device may manage the risk of occurrence of the per row hammer phenomenon to be an appropriate level or lower. This may mean that the row hammer phenomenon is effectively prevented.

A memory device according the present disclosure may effectively prevent a row hammer phenomenon.

While this disclosure contains many specific implementation details, these should not be construed as limitations on the scope of what may be claimed, equivalents thereof, as well as claims to be described later. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

The invention may also be defined by any of the following numbered paragraphs.
1. A memory device comprising:
   at least one bank including memory cells; and
   a register corresponding to the at least one bank,
   wherein the at least one bank includes:
      a plurality of rows arranged in a row direction; and
      a plurality of count cells each configured to store count data associated with the number of times of access of each of the plurality of rows, and
   wherein the register is configured to store an address and count data, which are associated with at least one row among the plurality of rows.
2. The memory device of paragraph 1, wherein the at least one bank further includes:
   a plurality of parity cells each configured to store parity data associated with the count data of each of the plurality of rows.
3. The memory device of paragraph 1 or 2, further comprising:
   a row hammer management circuit configured to manage the count data of each of the plurality of rows of the bank,
   wherein the row hammer management circuit updates the register by using an address and modified count data, which correspond to an access-requested target row.
4. The memory device of paragraph 3, wherein the row hammer management circuit updates the register, based on a comparison result of the modified count data corresponding to the target row and count data of at least one row stored in the register.
5. The memory device of paragraph 3 or 4,
   wherein, when the modified count data corresponding to the target row are larger than minimum count data among pieces of count data of a plurality of rows stored in the register,
   the row hammer management circuit replaces an entry of the register corresponding to the minimum count data with the address and the modified count data of the target row.
6. The memory device of any one of paragraphs 3 to 5, wherein, when the modified count data corresponding to the target row are smaller than minimum count data among pieces of count data of a plurality of rows stored in the register, the row hammer management circuit maintains an entry of the register corresponding to the minimum count data.
7. The memory device of any one of paragraphs 3 to 6, wherein, when the address corresponding to the target row coincides with an address stored in the register, the row hammer management circuit replaces previous count data corresponding to the target row stored in the register with the modified count data corresponding to the target row.
8. The memory device of any one of paragraphs 3 to 7, wherein, when the address corresponding to the target row does not coincide with an address stored in the register and an empty space is present in the register, the row hammer management circuit generates an entry including the address and the modified count data, which correspond to the target row.
9. The memory device of any one of paragraphs 3 to 8, wherein, when the modified count data corresponding to the target row are smaller than a reference number, the row hammer management circuit postpones the update of the register.
10. The memory device of any one of paragraphs 3 to 9, wherein a row hammer refresh operation is performed based on the address and the count data of the at least one row stored in the register.
11. The memory device of paragraph 10, wherein a row hammer management operation is performed when maximum count data among count data of at least one row managed in the register are larger than or equal to a reference number.
12. The memory device of any preceding paragraph, wherein a row, whose count data are the largest, from among a plurality of rows managed in the register is designated as a management aggressor row.
13. The memory device of paragraph 12, wherein the count data of the management aggressor row are smaller than at least one of the count data respectively stored in the plurality of count cells.
14. The memory device of paragraph 12 or 13, wherein the count data of the management aggressor row are reset after there is performed a refresh operation on at least one victim row adjacent to the management aggressor row.
15. The memory device of paragraph 14, wherein count data corresponding to the at least one victim row increase after the refresh operation on the at least one victim row is performed.
16. The memory device of paragraph 1 or 2, further comprising:
   a row hammer management circuit configured to manage the count data of each of the plurality of rows of the bank,
   wherein the row hammer management circuit modifies the count data of each of the plurality of rows, based on the number of times of access and an activation time.
17. An operating method of a memory device, the method comprising:
   managing count data being the number of times of access of each of a plurality of rows, by using count cells of a count cell area of a bank;
   managing an address and the count data, which are associated with at least one row among the plurality of rows, by using a register; and
   performing a row hammer refresh operation, based on the address and the count data of the at least one row managed in the register.
18. The method of paragraph 17, wherein the managing of the address and the count data, which are associated with the at least one row among the plurality of rows, by using the register includes:
   comparing modified count data corresponding to a target row with the count data of the at least one row managed in the register; and
   when the modified count data corresponding to the target row are larger than the count data of the at least one row in the register, updating the register by using an address and the modified count data, which correspond to the target row.
19. The method of paragraph 17 or 18, wherein the performing of the row hammer refresh operation includes:
   designating a row, whose count data are the largest, from among a plurality of rows managed in the register as a management aggressor row;
   performing a victim row refresh operation on at least one victim row adjacent to the management aggressor row; and
   resetting the count data of the management aggressor row.
20. A memory device comprising:
   a bank including a plurality of count cells each configured to store count data being the number of times of access of each of the plurality of word lines;
   a register configured to store at least some count data among the plurality of count data stored in the plurality of count cells; and
   a row hammer management circuit configured to manage the plurality of count data stored in the plurality of count cells and the at least some count data stored in the register,
   wherein the row hammer management circuit updates the register, based on a comparison result of modified count data corresponding to an access-requested word line and the at least some count data stored in the register.

## Claims

1. A memory device comprising:
at least one bank including memory cells; and
a register corresponding to the at least one bank,
wherein the at least one bank includes:
a plurality of rows arranged in a row direction; and
a plurality of count cells, each configured to store count data of each of the plurality of rows, the count data being associated with a number of times of access of each of the plurality of rows, and
wherein the register is configured to store an address and count data of at least one row among the plurality of rows.

2. The memory device of claim 1, wherein the at least one bank further includes:
a plurality of parity cells, each configured to store parity data associated with the count data of each of the plurality of rows.

3. The memory device of claim 1 or 2, further comprising:
a row hammer management circuit configured to manage the count data of each of the plurality of rows,
wherein the row hammer management circuit is configured to update the register by using an address and modified count data that correspond to a target row identified in an access request.

4. The memory device of claim 3, wherein the row hammer management circuit is configured to update the register, based on a comparison result of the modified count data corresponding to the target row and the count data of at least one row stored in the register.

5. The memory device of claim 3 or 4,
wherein the row hammer management circuit is configured to, based on the modified count data corresponding to the target row being larger than minimum count data of the count data of the plurality of rows stored in the register, replace an entry of the register corresponding to the minimum count data with the address and the modified count data of the target row.

6. The memory device of any one of claims 3 to 5, wherein the row hammer management circuit is configured to, based on the modified count data corresponding to the target row being smaller than minimum count data among the count data of the plurality of rows stored in the register, maintain an entry of the register corresponding to the minimum count data.

7. The memory device of any one of claims 3 to 6, wherein the row hammer management circuit is configured to, based on the address corresponding to the target row matching an address stored in the register, replace previous count data corresponding to the target row stored in the register with the modified count data corresponding to the target row.

8. The memory device of any one of claims 3 to 7, wherein the row hammer management circuit is configured to, based on the address corresponding to the target row not matching an address stored in the register and based further on an empty space being present in the register, generate an entry including the address and the modified count data that correspond to the target row.

9. The memory device of any one of claims 3 to 8, wherein the row hammer management circuit is configured to, based on the modified count data corresponding to the target row being smaller than a reference number, postpone the update of the register.

10. The memory device of any one of claims 3 to 9, wherein the row hammer management circuit is configured to perform a row hammer refresh operation based on the address and the count data of the at least one row stored in the register.

11. The memory device of claim 10, wherein the row hammer refresh operation is performed based on maximum count data among count data of at least one row managed in the register being larger than or equal to a reference number.

12. The memory device of any preceding claim, wherein a row having the largest count data among a plurality of rows managed in the register is designated as a management aggressor row.

13. The memory device of claim 12, wherein the count data of the management aggressor row is smaller than at least one of the count data respectively stored in the plurality of count cells.

14. The memory device of claim 12 or 13, wherein the count data of the management aggressor row is reset after performing a refresh operation on at least one victim row adjacent to the management aggressor row.

15. The memory device of claim 14, wherein count data corresponding to the at least one victim row increases after the refresh operation on the at least one victim row is performed.
